# EUROPÄISCHE PATENTSCHRIFT

(11) **EP 0 854 668 B1**
(45) Veröffentlichungstag und Bekanntmachung des Hinweises auf die Patenterteilung: **08.12.2004**
(21) Anmeldenummer: 98890016.3
(22) Anmeldetag: 19.01.1998
(51) Int. Cl.: H05K 7/14, H02G 3/00

(54) **EIB-Gerät zum Einbau in eine Installationsdose**
EIB-(European Installation bus) device for flush mounting in a housing
Dispositif EIB à encastrer dans un boîtier

(30) Priorität: 21.01.1997 AT 8497
(43) Veröffentlichungstag der Anmeldung: 22.07.1998
(60) Teilanmeldung: 04008528.4
(73) Patentinhaber: Felten & Guilleaume Austria AG, 3943 Schrems (AT)
(72) Erfinder: Zöchling,Martin, 3872 Amaliendorf (AT)
(74) Vertreter: Gibler, Ferdinand, Dipl.-Ing. Dr.

(56) Entgegenhaltungen:
- EP-A- 0 620 525
- EP-A- 0 759 651
- DE-C- 4 140 611
- FR-A- 2 652 686

## Beschreibung

Die Erfindung betrifft ein EIB-Gerät, geeignet zum Einbau in eine Installationsdose, welches einen Busanschluß, einen Netzanschluß, Anschlüsse für anzusteuernde Verbraucher und/oder Sensoren sowie eine Steuerelektronik umfaßt.

Der EIB (European Installation Bus) ist ein Bussystem, das zur Bedienung der in einem Gebäude installierten Elektrogeräte, wie z.B. Licht, Jalousien, Ventilatoren, Heizung, Alarmanlage od. dgl. konzipiert ist. Jeder Verbraucher und jedes Bedienungselement, wie z.B. Taster, Schalter, Dimmer od. dgl. wird mit einem entsprechenden Interface-Baustein, dem Busankoppler, versehen und an den als Zwei-Draht-Bus ausgeführten EIB angeschlossen. Beim EIB verfügt jeder Busteilnehmer über einen eigenen Mikroprozessor und kann somit selbständig und unabhängig von einem zentralen Prozessor seine Daten verwalten. Wird z.B. ein Taster betätigt, der die Beleuchtung schalten soll, so sendet sein Busankoppler ein Datentelegramm auf den Datenbus. Alle Teilnehmer empfangen dieses Telegramm, jedoch nur die Steuerelektronik des betroffenen Gerätes, also der Beleuchtung, verarbeitet diese Daten weiter, betätigt ein Schaltorgan und verbindet damit die Beleuchtung mit dem Spannungsnetz. Die Datenübertragung und die Spannungsversorgung der Geräte erfolgt über ein einziges Adernpaar.

Eine den EIB verwendende Installation kommt im Vergleich zur herkömmlichen Installation mit einer wesentlich geringeren Leitungsanzahl aus, ist einfacher zu erweitern und ist bedarfsweise durch einfache Umprogrammierung der Signalgeber und der Verbraucher in ihrer Funktion veränderbar.

Bislang wurden EIB-fähige Geräte relativ groß aufgebaut und lediglich für den Einbau in Schaltschränke oder in große Kabeltrassen, wie sie in Zweckbauten (Bürogebäude, öffentliche Gebäude) vorgesehen sind, konzipiert. Damit lastete dem an sich günstigen EIB der Nachteil des unverhältnismäßig hohen Platzbedarfes an.

In letzter Zeit wurde es -bedingt durch die Miniaturisierung der elektronischen Bauteilemöglich, die wesentlichen Komponenten von EIB-Geräten, nämlich Busankoppler und zugehörige Schaltorgan-Ansteuerelektronik entscheidend zu verkleinern, sodaß an die Konstruktion von "kleinen" EIB-Geräten, die in herkömmliche Installationsdosen eingebaut werden können, gedacht werden kann.

Verbunden mit dieser kleinen Bauform ist das Problem, daß die Anschlüsse für den niedrige Gleichspannungen (Uₙₑₙₙ=29V) führenden Datenbus räumlich sehr nahe den Netzspannung führenden Geräteanschlüssen (Netzzuleitung, geschaltete Anschlüsse für die zu steuernden Verbraucher) rücken können und damit eine zur ausreichenden Isolierung dienende Beabstandung der Bus- von den netzseitigen Anschlüssen Schwierigkeiten bereitet.

Es ist Aufgabe der Erfindung, ein EIB-Gerät der eingangs erwähnten Art anzugeben, bei dem eine besonders gute Isolierung der Bus- von der Netzseite gegeben ist.

Erfindungsgemäß wird dies dadurch erreicht, daß das EIB-Gerät eine erste und zumindest eine zweite Schaltungsträgerplatte aufweist, welche einen im wesentlichen rechten Winkel miteinander einschließend aneinander festgelegt sind, und daß der Busanschluß im neben der ersten Seite der zumindest einen zweiten Schaltungsträgerplatte liegenden ersten Geräte-Bereich und der Netzanschluß sowie die Verbraucheranschlüsse im neben der anderen Seite der zumindest einen zweiten Schaltungsträgerplatte liegenden zweiten Geräte-Bereich angeordnet sind.

Damit ist ein besonders großer Abstand zwischen Bus- und Netzseite erreichbar, zusätzlich fungiert die zweite Schaltungsträgerplatte als Trennwand zwischen Bus- und

Netzanschlüssen, sodaß eine konstruktive Abschottung zwischen Bus- und Netzseite gegeben ist.

In Weiterbildung der Erfindung kann vorgesehen sein, daß der Netzanschluß sowie die Verbraucheranschlüsse an einer dritten Schaltungsträgerplatte angeordnet sind, welche dritte Schaltungsträgerplatte im wesentlichen senkrecht zur ersten Schaltungsträgerplatte verlaufend an dieser festgelegt ist.

Dies erlaubt eine von der ersten Schaltungsträgerplatte beabstandete Festlegung der Anschlüsse, im dadurch freiwerdenden Raum zwischen den Anschlüssen und der ersten Schaltungsträgerplatte können weitere Schaltungskompönenten angeordnet werden.

Nach einer besonders bevorzugten Ausführungsform der Erfindung kann vorgesehen sein, daß die dritte Schaltungsträgerplatte niedriger als die zumindest eine zweiten Schaltungsträgerplatte ist.

Damit ist auch oberhalb der Anschlüsse eine pysikalische Trennung der Bus- von der Netzseite gegeben.

Ein weiteres Merkmal der Erfindung kann sein, daß der Netzanschluß sowie die Verbraucheranschlüsse durch Federkraftklemmen gebildet sind.

Dies erlaubt eine besonders einfache Verdrahtung des erfindungsgemäßen EIB-Gerätes.

In diesem Zusammenhang kann weiters vorgesehen sein, daß die Aufnahmekanäle der Federkraftklemmen im wesentlichen senkrecht zur ersten Schaltungsträgerplatte verlaufend angeordnet sind.

Üblicherweise wird das EIB-Gerät so in die Installationsdose eingesetzt, daß seine erste Schaltungsträgerplatte parallel zum Boden der Dose verläuft. Durch die erfindungsgemäße Anordnung der Federkraftklemmen sind diese auch nach erfolgter Einsetzung des EIB-Gerätes in eine Installationsdose zugänglich.

In weiterer Ausbildung der Erfindung kann vorgesehen sein, daß der Busanschluß an der ersten Schaltungsträgerplatte, vorzugsweise im wesentlichen senkrecht zu dieser verlaufend, festgelegt ist.

Der Busanschluß ist dadurch -analog zu den senkrecht zur ersten Schaltungsträgerplatteangeordneten Federkraftklemmen- ebenfalls auch noch nach Einsetzen des EIB-Gerätes in eine Installationsdose gut zugänglich.

Die Erfindung wird nachstehend an Hand der in den Figuren dargestellten bevorzugten Ausführungsform näher erläutert. Es zeigt:
Fig.1 ein Blockschaltbild eines erfindungsgemäßen EIB-Gerätes; und
Fig.2a,b,c die konstruktive Ausführung der Erfindung in Auf- Grundriß und Seitenriß;

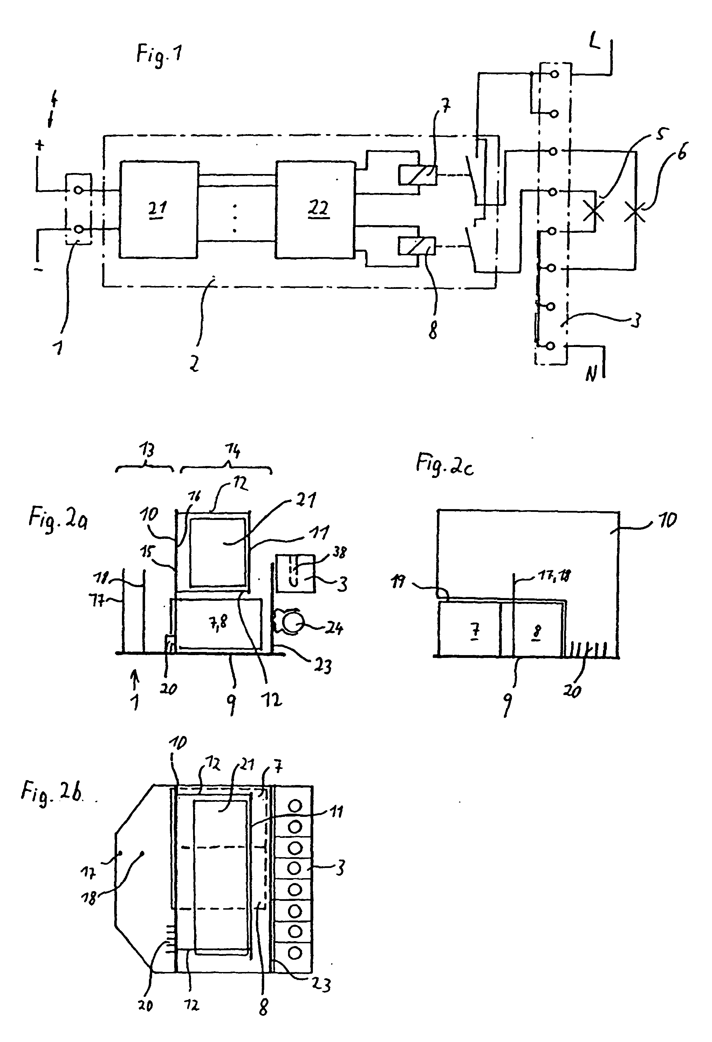

Wie am besten aus Fig.1 ersichtlich, weist ein EIB-Gerät die Baugruppen Busanschluß 1, Steuerelektronik 2 sowie Netz- und Verbraucheranschlüsse 3 auf. Die Steuerelektronik 2 kann noch unterteilt werden in Busankoppler 21 und Verbraucheransteuerschaltung 22. Der Busankoppler 21 überwacht den Bus 4 ständig und gibt -wie eingangs schon erwähnt- nur dann entsprechende Steueranweisungen an die Ansteuerschaltung 22 weiter, wenn das gerade empfangene Datenpaket tatsächlich an ihn adressiert ist. Die Ansteuerschaltung 22 hat nun die Aufgabe, die relativ energiearmen Steueranweisungen des Busankopplers 21 in tatsächliche Schalthandlungen umzusetzen. Im zur Erläuterung der Erfindung dienenden Beispiel soll das EIB-Gerät zwei Verbraucher 5,6 ein- und ausschalten, wozu Relais 7,8 verwendet werden.

Die Anschlüsse für den Phasen- L und den Neutralleiter N sind zum einen mit den Schaltkontakten der Relais 7,8, daneben aber auch jeweils mit einem zweiten Anschluß verbunden, Phasen- und Neutralleiter werden damit durch das erfindungsgemäße EIB-Gerät durchgeschleift. Für den Anschluß weiterer Geräte an die Netzzuleitungen sind dadurch keine zusätzlichen, vom EIB-Gerät separate Klemmen erforderlich.

Ein EIB-Gerät mit einem derartigen Blockschaltbild soll nun zumindest so klein aufgebaut werden, daß es in eine Installationsdose eingebaut werden kann. Zur Erreichung dieses Zieles wird erfindungsgemäß der in Fig.2 dargestellte Aufbau verwendet. Die Bauteile von Busankoppler 21 und Ansteuerschaltung 22 werden dabei auf zumindest zwei Schaltungsträgerplatten 9,10 verteilt. Die erste Schaltungsträgerplatte 9 bildet dabei gleichsam die "Grundplatte" des EIB-Gerätes, die zumindest eine zweite Schaltungsträgerplatte 10 ist im wesentlichen rechtwinkelig zur ersten Schaltungsträgerplatte 9 verlaufend angeordnet und an dieser festgelegt. Diese Festlegung erfolgt vorzugsweise mithilfe der ohnehin notwendigen elektrischen Verbindungsleitungen 20, die als an sich bekannte rechtwinkelige Anschlußpins ausgebildet sind.

Ein erfindungsgemäßes EIB-Gerät wird so in eine Installationsdose eingesetzt, daß seine erste Schaltungsträgerplatte 9 parallel zum Boden der Installationsdose verläuft. Daher ist es günstig, diese Schaltungsträgerplatte 9 entsprechend dem Boden einer Installationsdose zu gestalten. Beim dargestellten Aufbau wurde eine Anpassung des Umrisses der Schaltungsträgerplatte 9 an den Boden einer runden Installationsdose in einfacher Weise dadurch erreicht, daß zwei Ecken einer an sich rechteckigen Schaltungsträgerplatte abgeschrägt wurden.

Der Busankoppler 22 ist als kompakte Baueinheit vorhanden, sämtliche seiner Bauteile sind auf einer weiteren, nicht direkt mit der zweiten Schaltungsträgerplatte 10 verbundenen weiteren Schaltungsträgerplatte 11 angeordnet. Die beiden Schaltungsträgerplatten 10 und 11 und damit Busankoppler 21 und Ansteuerschaltung 22 stehen über Verbindungsstifte 12 sowohl in elektrischer als auch in mechanischer Verbindung.

Die Bauteile der Ansteuerschaltung 21 sind mit Ausnahme der Relais 7,8, die direkt an der Grundplatte 9 unterhalb des Busankopplers 22 angeordnet sind, auf der zweiten Schaltungsträgerplatte 10 angebracht. Beim zur Erklärung der Erfindung gewählten Aufbau ist die Schaltungsträgerplatte 10 mit einer Ausnehmung 19 versehen, welche es ermöglicht, die Relais 7,8 abschnittsweise unterhalb der Schaltungsträgerplatte 10 anzuordnen.

Die in den Zeichnungen dargestellte eine zweite Schaltungsträgerplatte 10 kann bedarfsweise durch mehrere zueinander parallele und jede für sich an der ersten Schaltungsträgerplatte 9 festgelegte Schaltungsträgerplatten ersetzt werden. Desweiteren ist die Funktion eines erfindungsgemäßen EIB-Gerätes nicht auf die in Fig.1 dargestellte beschränkt, jedes EIB-Gerät kann unabhängig von seiner Funktion in der erfindungsgemäßen Weise aufgebaut werden.

Die zumindest eine zweite Schaltungsträgerplatte 10 teilt das EIB-Gerät in einen ersten, neben seiner ersten -in Fig. 2a,b der linken Seite 15- liegenden Bereich 13 und in einen zweiten, neben der zweiten (rechten) Seite 16 der Schaltungsträgerplatte 10 liegenden Bereich 14.

Der Busanschluß 1, der vorschriftsgemäß bei jedem EIB-Gerät aus zwei Stiften 17,18 zu bestehen hat, ist erfindungsgemäß im ersten Bereich 13, die Netz- und Verbraucheranschlüsse 3 sind hingegen im zweiten Bereich 14 angeordnet. Damit ist die zweite Schaltungsträgerplatte 10 zwischen Bus- 1 und Netz-Nerbraucheranschlüssen 3 angeordnet, diese weisen nicht nur den weitest möglichen räumlichen Abstand voneinander auf, sondern sind zusätzlich durch die Schaltungsträgerplatte 10 voneinander abgeschottet.

Wo und wie der Busanschluß 1 bzw. die Netz- und Verbraucheranschlüsse 3 in den genannten Bereichen angeordnet sind, ist prinzipiell beliebig. So könnten sie z.B. direkt auf der ersten 9 oder der zweiten Schaltungsträgerplatte 10 oder auf weiteren Schaltungsträgerplatten angeordnet sein. Besonders günstig hat es sich allerdings erwiesen, den Busanschluß 1 direkt an der ersten Schaltungsträgerplatte 9 so festzulegen, daß seine beiden Anschlußstifte 17, 18 senkrecht zu dieser verlaufen.

Netz- sowie Verbraucheranschlüsse 3 werden hingegen an einer dritten Schaltungsträgerplatte 23 angeordnet, welche dritte Schaltungsträgerplatte 23 im wesentlichen senkrecht zur ersten Schaltungsträgerplatte 9 verlaufend an dieser festgelegt ist. Diese dritte Schaltungsträgerplatte 23 bringt in zweifacher Hinsicht Vorteile für den Geräteaufbau: Zum einen können die Netz-/Verbraucheranschlüsse 3 beabstandet von der ersten Schaltungsträgerplatte 9 angeordnet werden. Da das erfindungsgemäße EIB-Gerät so in eine Installationsdose eingesetzt wird, daß die erste Schaltungsträgerplatte 9 am Boden der Installationsdose anliegt, rücken die Netz-/Verbraucheranschlüsse 3, die vorzugsweise durch Federkraftklemmen gebildet sind, näher an die Öffnung der Installationsdose, sind damit für den Monteur leichter zugänglich und erlauben eine besonders einfache Verdrahtung des EIB-Gerätes.

Die Tatsache, daß die Federkraftklemmen zusätzlich dazu so auf der dritten Schaltungsträgerplatte 23 festgelegt sind, daß ihre Aufnahmekanäle 38 im wesentlichen senkrecht zur ersten Schaltungsträgerplatte 9 verlaufen, trägt ebenfalls zur Vereinfachung der Verdrahtung bei, diese kann dadurch nämlich auch dann, wenn das EIB-Gerät in der Installationsdose eingesetzt ist, problemlos vorgenommen werden.

Der zweite Vorteil der Verwendung einer dritten Schaltungsträgerplatte 23 für die Festlegung der Netz-/Verbraucheranschlüsse 3 liegt darin, daß auf ihr Bauteile der Busankoppelschaltung 22 angeordnet werden können. Bei der in den Zeichnungen dargestellten Ausführungsform der Erfindung wurde davon Gebrauch gemacht und eine Glasrohr-Sicherung 24, die zum Schutz der Verbraucheranschlüsse vor Überströmen dient, unterhalb der Netz-/Verbrauchanschlüsse 3 vorgesehen.

Besagte dritte Schaltungsträgerplatte 23 ist niedriger als die zumindest eine zweite Schaltungsträgerplatte 10 ausgeführt. Damit überragt die zweite Schaltungsträgerplatte 10 sowohl den Busanschluß 1 wie auch die Netz-/Verbrauchanschlüsse 3, wodurch eine besonders gute Abschottung der Bus- von der Netzseite gegeben ist.

## Patentansprüche

1. EIB-Gerät, geeignet zum Einbau in eine Installationsdose, welches einen Busanschluß (1) , einen Netzanschluß, Anschlüsse für anzusteuernde Verbraucher und/oder Sensoren (3) sowie eine Steuerelektronik (2) umfaßt, **dadurch gekennzeichnet, daß** das EIB-Gerät eine erste (9) und zumindest eine zweite Schaltungsträgerplatte (10) aufweist, welche einen im wesentlichen rechten Winkel miteinander einschließend aneinander festgelegt sind, und daß der Busanschluß (1) im neben der ersten Seite (15) der zumindest einen zweiten Schaltungsträgerplatte (10) liegenden ersten Geräte-Bereich (13) und der Netzanschluß sowie die Verbraucheranschlüsse (3) im neben der anderen Seite (16) der zumindest einen zweiten Schaltungsträgerplatte (10) liegenden zweiten Geräte-Bereich (14) angeordnet sind.

2. EIB-Gerät nach Anspruch 1, **dadurch gekennzeichnet, daß** der Netzanschluß sowie die Verbraucheranschlüsse (3) an einer dritten Schaltungsträgerplatte (23) angeordnet sind, welche dritte Schaltungsträgerplatte (23) im wesentlichen senkrecht zur ersten Schaltungsträgerplatte (9) verlaufend an dieser festgelegt ist.

3. EIB-Gerät nach Anspruch 1 oder 2, **dadurch gekennzeichnet, daß** die dritte Schaltungsträgerplatte (23) niedriger als die zumindest eine zweiten Schaltungsträgerplatte (10) ist.

4. EIB-Gerät nach einem der Ansprüche 1 bis 3, **dadurch gekennzeichnet, daß** der Netzanschluß sowie die Verbraucheranschlüsse (3) durch Federkraftklemmen gebildet sind.

5. EIB-Gerät nach Anspruch 4, **dadurch gekennzeichnet, daß** die Aufhahmekanäle (38) der Federkraftklemmen im wesentlichen senkrecht zur ersten Schaltungsträgerplatte (9) verlaufend angeordnet sind.

6. EIB-Gerät nach einem der vorstehenden Ansprüche, **dadurch gekennzeichnet, daß** der Busanschluß (1) an der ersten Schaltungsträgerplatte (9), vorzugsweise im wesentlichen senkrecht zu dieser verlaufend, festgelegt ist.

## Claims

1. An EIB (European installation bus) device for flush mounting in a housing, which device comprises a bus connection (1), a mains connection, connections for consumers and/or sensors (3) to be triggered as well as an electronic control system (2), **characterized in that** the EIB device comprises a first (9) and at least one second circuit support plate (10) which are fixed to each other so as to enclose a substantially right angle with each other, and that the bus connection (1) is arranged in the first device region (13) adjacent to the first side (15) of the at least one second circuit support plate (10) and the mains connection as well as the consumer connections (3) are arranged in the second device region (14) adjacent to the other side (16) of the at least one second circuit support plate (10).

2. An EIB device as claimed in claim 1, **characterized in that** the mains connection as well as the consumer connections (3) are arranged on a third circuit support plate (23), which third circuit support plate (23) is fixed to the first circuit support plate (9) by extending substantially perpendicular to the latter.

3. An EIB device as claimed in claim 1 or 2, **characterized in that** the third circuit support plate (23) is lower than the at least one second circuit support plate (10).

4. An EIB device as claimed in one of the claims 1 to 3, **characterized in that** the mains connection and the consumer connections (3) are formed by spring-power terminals.

5. An EIB device as claimed in claim 4, **characterized in that** the receiving channels (38) of the spring-power terminals are arranged so as to extend substantially perpendicular to the first circuit support plate (9).

6. An EIB device as claimed in one of the preceding claims, **characterized in that** the bus connection (1) is fixed to the first circuit support plate (9), preferably by extending substantially perpendicular to the same.

## Revendications

1. Dispositif EIB pouvant être intégré dans un boîtier d'installation et présentant une connexion de bus (1), une connexion au réseau, des connecteurs pour les consommateurs et/ou détecteurs à commander (3) ainsi que des circuits électroniques de commande (2), **caractérisé en ce que** le dispositif EIB présente une première carte porte-circuits (9) et au moins une deuxième (10), qui sont fixées sensiblement à angle droit l'une par rapport à l'autre, et **en ce que** la connexion de bus (1) est disposée dans la première zone de dispositif (13) se trouvant près du premier côté (15) de la deuxième carte porte-circuits (10) au nombre d'une au moins et la connexion au secteur ainsi que les connecteurs pour les consommateurs (3) dans la deuxième zone du dispositif (14) située près de l'autre côté (16) de la deuxième carte porte-circuits (10) au nombre d'une au moins.

2. Dispositif EIB selon la revendication 1, **caractérisé en ce que** la connexion au secteur ainsi que les connecteurs pour les consommateurs (3) sont disposés sur une troisième carte porte-circuits (23), laquelle troisième carte porte-circuits (23) est fixée sur la première carte porte-circuits (9) et sensiblement perpendiculaire à celle-ci.

3. Dispositif EIB selon la revendication 1 ou 2, **caractérisé en ce que** la troisième carte porte-circuits (23) est plus basse que la deuxième carte porte-circuits (10) au nombre d'une au moins.

4. Dispositif EIB selon l'une quelconque des revendications 1 à 3, **caractérisé en ce que** la connexion au secteur ainsi que les connecteurs pour les consommateurs (3) sont formés par des bornes élastiques.

5. Dispositif EIB selon la revendication 4, **caractérisé en ce que** les goulottes de logement (38) des bornes élastiques sont sensiblement perpendiculaires à la première carte porte-circuits (9).

6. Dispositif EIB selon l'une quelconque des revendications précédentes, **caractérisé en ce que** la connexion de bus (1) est fixée sur la première carte porte-circuits (9), de préférence de façon sensiblement perpendiculaire à celle-ci.
